## Europäisches Patentamt
## European Patent Office
## Office européen des brevets

(19)

(11) Publication number:

**0 050 417**
**A1**

(12)

# EUROPEAN PATENT APPLICATION

(21) Application number: 81304267.8

(22) Date of filing: 17.09.81

(51) Int. Cl.³: **H 02 H 3/04**, H 03 K 17/18,
G 08 B 21/00

(30) Priority: 17.10.80 US 197888

(43) Date of publication of application: 28.04.82
Bulletin 82/17

(84) Designated Contracting States: CH DE FR GB IT LI NL

(71) Applicant: HONEYWELL INC., Honeywell Plaza,
Minneapolis Minnesota 55408 (US)

(72) Inventor: Black, Jr., Robert A., 7007 Girard Avenue North,
Brooklyn Center Minnesota 55430 (US)

(74) Representative: Riddle, John et al, Honeywell Control
Systems Ltd. Patent Department Charles Square,
Bracknell, Berks. (GB)

(54) Opto-isolator device.

(57) An opto-isolator device comprises a light emitting
diode (23) and a light responsive transistor (25) which
is electrically switched when the diode emits light onto
the transistor, and an electric switch (11) which con-
nects an electric load (20) to a source of alternating
current (13). The device also includes a rectifier circuit
(17, 21, 22, 23, 27, 30 and 32) which continuously checks
the state of switch (11) such that if the switch is open
the output of the device is a half wave rectified signal
and such that if the switch is closed the device output
is a full wave rectified signal.

ACTORUM AG

- 1 -

OPTO-ISOLATOR DEVICE

Background of the Invetion

The use of opto-isolators in electronic circuits has become quite common where electrical isolation between two circuit portions is desirable. Opto-isolators typically are made up of a light tight package including a light emitting diode and a light responsive transistor. The electrical separation is created by the transmission of information by the light from the light emitting diode to the light responsive transistor. In addition to providing electrical isolation, the opto-isolator has been used extensively as an indicating or control device. This is true where the light emitting diode is energized in response to the energization of some other circuit portion so that the light responsive transistor can indicate or control further circuit elements. While the elements that make up an opto-isolator are normally quite reliable, there is always a possibility that the light emitting diode or the associated transistor could fail and the opto-isolator therefore become inoperative without that fact being known. In certain types of safety related equipment, such as flame safeguard equipment, the failure of an opto-isolator in a control or indicating circuit could be very serious. In recent years flame safeguard equipment itilizing microprocessors for control of the sequence of burner operations have been developed. Opto-isolators are used to convey information as to the status of relay contacts in the burner control system to the microprocessor. In this type of equipment the opto-isolators have been used for voltage isolation as well as for transmission of critical data. The failure of an opto-isolator in a critical circuit, such as a control circuit to a fuel valve, could cause an explosive situation at a burner or boiler.

According to the invention, there is provided an opto-isolator device comprising a light emitting diode and a light responsive transistor which is electrically switched when said diode emits light onto the transistor, and an electric switch connecting an electric load to a source of alternating current, characterized in that a rectifier circuit (17,21,22,23,27,30 and 32) is provided to continuously check the state of said switch such that if the switch is open the output of said device is a half wave rectified signal and such that if the switch is closed the device output is a full wave rectified signal.

An embodiment of the invention will now be described by way of example only, with reference to the accompanying drawings, in which:-

Figure 1 is a simplified circuit diagram of an opto-isolator device of the present invention, and

Figure 2 is a representation of wave forms provided by the device of Figure 1.

Description of the preferred Embodiment

Referring to the drawings, the opto-isolator device includes an indicator or output 10 which senses or indicates the status of a switch 11. The indicator or output 10 more typically would be a control circuit including an internal relay 12 to control the switch 11. The indicator or output 10 in fact is a microprocessor that is capable of both controlling the output relay and the switch 11, while responding to the status by reading the state of the switch 11.

The switch 11 is connected in series with a load 20 across an alternating current voltage source 13 via terminals 14 and 15 and conductors 16 and 17. The load 20 is monitored either for safety or merely for indication. The load 20 typically would be a fuel valve in a burner control system which is controlled and monitored by the output 10 which would preferably be a microprocessor controlled unit.

The switch 11 and load 20 are connected in common by a diode 21 which in turn is connected through an impedance 22 which limits current through a light emitting diode 23 of an opto-isolator 24 that further includes a light responsive transistor 25. The opto-isolator 24 is a well known voltage or signal isolating circuit where the light emitting diode 23 causes a switching action in the transistor 25 whenever a light 26 emits from diode 23. The light emitting diode 23 is connected via conductor 26 through a further diode 27 to the conductor 17 that is common to the load 20. The switch 11, and diode 21, the impedance 22, the light emitting diode 23, and the further diode 27 form a first indicator circuit and it is quite apparent that when the switch 11 are closed current will be drawn through the light emitting diode 23 to generate the light 26 to cause the transistor 25 to switch.

The dynamic contact checking circuit further includes a diode 30 that is connected from the conductor 17 to a point 31 that is common between the diodes 21 and the impedance 22. A diode 32 is connected from the conductor 26 to the conductor 16 and completes the input or indicating portion of the circuit. It will be noted that a circuit can be completed from the conductor 17 through the diode 30, the resistor or impedance 22, the light emitting diode 23, and the diode 32 to the conductor 16 thereby placing this second indicator circuit across the source of alternating current potential 13. The operations of the first indicator circuit and the second indicator circuit will be described after the device is disclosed in its entirety.

The transistor 25 is supplied with voltage source 35 through a resistor 36 to ground 37 in a conventional fashion. With this arrangement an output voltage $V_{out}$ is provided on a conductor 40 with respect to a ground conductor 41 that is connected to the ground 37. The output voltage between conductors 40 and 41 is a switched output that is responsive to the conductive and nonconductive states of the transistor 25 in response to the light 26 from the light emitting diode 23.

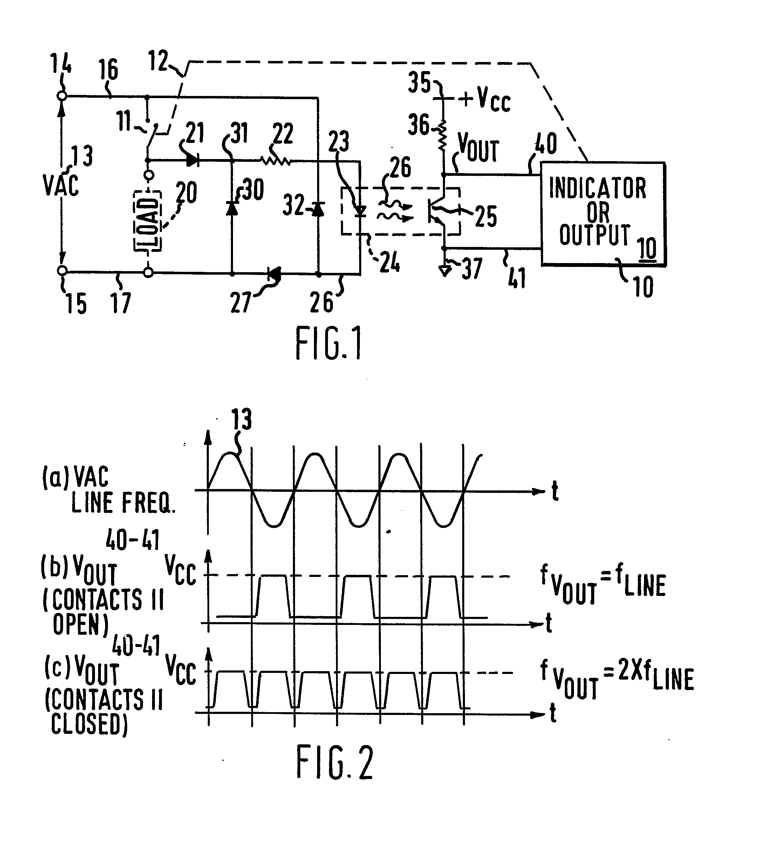

The operation of Figure 1 will be described in connection with the wave forms disclosed in Figure 2. In Figure 2(a) the alternating current potention 13 is shown as a conventional alternating current potential which typically would be the 60 hertz frequency supplied in conventional equipment. The particular frequency involved is not material and the system can be used on any type of an alternating current voltage. In Figure 2(b) a voltage output between the conductors 40 and 41 is disclosed when the switch 11 is in an open condition. It will be noted that the frequency of the pulses generated when the switch 11 is open is equal to the frequency of the alternating current potential 13. In Figure 2(c) the voltage output between the conductors 40 and 41 is disclosed with the switch 11 closed. It will be noted that the frequency of the output voltage has doubled and is now equal to twice the frequency of the alternating current potential 13. The way in which this is accomplished will now be described.

Considering Figure 1, with the voltage source 13 applied and the switch 11 open, the output voltage between conductors 40 and 41 is shown in Figure 2(b). This is accomplished by a current being drawn from the terminal 15 through the conductor 17 and the diode 30, the impedance 22, and the light emitting diode 23 where the current then returns via the diode 32 to the conductor 16 and the terminal 14. It is thus apparent that whenever the terminal 15 is positive potential with respect to the terminal 14, that a complete circuit has been established so that current can flow through the light emitting diode 23 to cause the transistor 25 to change state. The reversal of polarities of the line voltage 13 so that the terminal 14 is positive with respect to terminal 15 provides no current flow through the light emitting diode 23. Each complete cycle therefore generates an output frequency between the conductors 40 and 41 that equals the line frequency.

If the output 10 energizes its relay to close the switch 11, the wave form disclosed in Figure 2(c) occurs across the conductors 40 and 41. With the switch 11 closed, the first indicator circuit from the terminal 14 through the conductor 16 and the switch 11 is established. Current will flow through the diode 21, the impedance 22, the light emitting diode 23, and the diode 27 back to the terminal 15. When the polarity reverses on the terminals 14 and 15, the second indicator circuit is active as was described in connection with the switch 11 being open. This generates both halves of the output voltages shown in Figure 2(c) thereby providing an output on conductors 40 and 41 that is twice the frequency of the line voltage 13. If the output 10 is a microprocessor, it can easily read the frequencies to determine whether the contacts are open or closed.

Should a failure occur in the light emitting diode 23 or in the transistor 25, the voltage across the conductors 40 and 41 does not assume the dynamic output frequencies that are provided by the above described first and second indicator circuits, and this would be sensed by the output 10. With the arrangement just disclosed a very simple and reliable means of determining the state of the switch 11 has been established and the output 10 can respond safely in the event of any failure in the opto-isolator 24. With the output 10 having the capabilities of a microprocessor any equipment controlled thereby can respond almost immediately to a component failure or an inadvertent failure of the switch 11. More particularly, the present device is directed to sensing welded contacts of switch 11 in which the output 10 would call for the switch 11 to open, but its failure to open would immediately be detected as an improper voltage configuration between the conductors 40 and 41. The output 10 would then activate safety circuits to properly handle the situation of the welded contacts.

The device of Figure 1 could be used in a much simpler security type of system. The switch 11 could be manually operated which would immediately provide an indicator signal at indicator 10 to indicate whether or not the contacts

0050417

were open or closed.  If the system is used with a manual arrangement of opening and closing the switch 11, the output 10 would merely be an indicator without the previously mentioned microprocessor or relay for control functions. This is merely another application to which the present invention could be applied.

CLAIMS

1. An opto-isolator device comprising a light emitting diode and a light responsive transistor which is electrically switched when said diode emits light onto the transistor, and an electric switch connecting an electric load to a source of alternating current, characterized in that a rectifier circuit (17,21,22, 23,27,30 and 32) is provided to continuously check the state of said switch such that if the switch is open the output of said device is a half wave rectified signal and such that if the switch is closed the device output is a full wave rectified signal.

2. The device of Claim 1, characterized in that the rectifier circuit includes a first pair of diodes (21,27) connected in series with the light emitting diode and said switch to form a first circuit, and includes a second pair of diodes (30,32) connected in series with the light emitting diode to form a second circuit connected across the source of alternating current, the circuits being arranged such that with the switch closed said first and second circuits conduct current when the alternating current is positive and negative respectfully to provide full wave rectification.

3. The device of Claim 1 or 2, characterized in that transistor (25) is connected to an output (10) including a relay (12), said relay controlling said switch (11).

FIG.1

FIG.2

| Category | Citation of document with indication, where appropriate, of relevant passages | Relevant to claim | CLASSIFICATION OF THE APPLICATION (Int. Cl.³) |
|---|---|---|---|
| | **DOCUMENTS CONSIDERED TO BE RELEVANT** | | |
| A | <u>DE - A1 - 2 614 748</u> (BAUM ELEKTROPHYSIK GMBH) <br> * claims 3,4; page 6, line 16 to page 8, line 11; fig. 2 * | 1 | H 02 H 3/04 <br> H 03 K 17/18 <br> G 08 ⌐ 21/00 |
| A | <u>US - A - 3 387 135</u> (R.O. ENGH) <br> * column 1, lines 24 to 33; column 2, line 42 to column 3, line 31; fig. 1 * | 1 | |
| A | <u>US - A - 3 421 156</u> (W.G. ROWELL) <br> * column 1, line 9 to column 2, line 15 * | | |

**TECHNICAL FIELDS SEARCHED** (Int. Cl.³)

G 08 B 17/12
G 08 B 21/00
G 08 B 29/00
H 02 H 3/04
H 03 K 17/18

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| Berlin | 11-01-1982 | LEMMERICH |

EPO Form 1503.1 06.78